Europäisches Patentamt

European Patent Office

Office européen des brevets

(11) Veröffentlichungsnummer : **0 192 788**
**B1**

# (12) EUROPÄISCHE PATENTSCHRIFT

(45) Veröffentlichungstag der Patentschrift :
27.07.88

(21) Anmeldenummer : 85102004.0

(22) Anmeldetag : 23.02.85

(51) Int. Cl.⁴ : **H 03 D   3/00**

(54) Integrierte digitale Frequenzdemodulationsteilschaltung.

Ein Antrag gemäss Regel 88 EPÜ auf Berichtigung der Figur 3 liegt vor. Über diesen Antrag wird im Laufe des Verfahrens von der Prüfungsabteilung eine Entscheidung getroffen werden.

(43) Veröffentlichungstag der Anmeldung :
03.09.86 Patentblatt 86/36

(45) Bekanntmachung des Hinweises auf die Patenterteilung : 27.07.88 Patentblatt 88/30

(84) Benannte Vertragsstaaten :
DE FR NL

(56) Entgegenhaltungen :
EP-A- 0 035 166
EP-A- 0 059 133
EP-A- 0 080 014
FR-A- 2 219 570
FERNSEH & KINO TECHNIK, Band 37, Nr. 5, Mai 1983, Seiten 203-215, Berlin, DE; E. DEGUFFROY u.a.: "Kammfilter zur Decodierung von Videosignalen"

(73) Patentinhaber : Deutsche ITT Industries GmbH
Hans-Bunte-Strasse 19 Postfach 840
D-7800 Freiburg (DE)

(72) Erfinder : Mehrgardt, Sönke, Dr.
Häglestrasse 26
D-7801 March (DE)
Erfinder : Ehret, Bernhard, Dipl.-Ing.
Im Glaser 25
D-7800 Freiburg i.Br. (DE)

(74) Vertreter : Morstadt, Volker, Dipl.-Ing.
c/o Deutsche ITT Industries GmbH Patent/Lizenzabteilung Postfach 840 Hans-Bunte-Strasse 19
D-7800 Freiburg/Brsg. (DE)

## Beschreibung

Die Erfindung betrifft eine integrierte Frequenzdemodulationsteilschaltung entsprechend dem Oberbegriff des Anspruchs 1. Eine derartige Teilschaltung ist aus der Zeitschrift « Archiv der elektronischen Übertragung (AEÜ) », 1982, Seiten 292 bis 298 bekannt, insbesondere Bilder 1 und 2 auf Seiten 293 und 294. Dieser Stand der Technik beschäftigt sich mit der Frequenzdemodulation von Rundfunk-UKW-Signalen, wobei insbesondere auch die Demodulation des nach der europäischen Norm im UKW-Rundfunksignal enthaltenen Stereosignals mittels der Anordnung vorgenommen werden soll.

Der in den Ansprüchen gekennzeichneten Erfindung liegt demgegenüber die Aufgabe zugrunde, die im Oberbegriff des Anspruchs 1 definierte Teilschaltung so zu optimieren und auszugestalten, daß sie bei digitalen Frequenzdemodulatoren für SECAM-Farbfernsehsignale geeignet ist. Untersuchungen der Erfinder zeigen nämlich, daß die bekannte Anordnung zwar vom Prinzip her auch für SECAM-Demodulation geeignet ist, jedoch die hierfür erforderliche Kristallfläche der integrierten Schaltung unvertretbar groß wird. Die genannte Optimierung besteht also im wesentlichen darin, die Prinzipschaltung derart zu konzipieren, daß sich eine vertretbare Größe des Kristalls ergibt.

Die Erfindung wird nun anhand der Figuren der Zeichnung näher erläutert.

Fig. 1 zeigt das Prinzipschaltbild einer Ausführungsform der Frequenzdemodulationsteilschaltung nach der Erfindung,

Fig. 2 zeigt das Prinzipschaltbild einer vereinfachten Weiterbildung nach Fig. 1, und

Fig. 3 zeigt das Prinzipschaltbild einer für die Realisierung in Zweiphasen-Isolierschicht-Feldeffekttransistor-Technik vorgesehenen weiteren vereinfachten Ausführungsform.

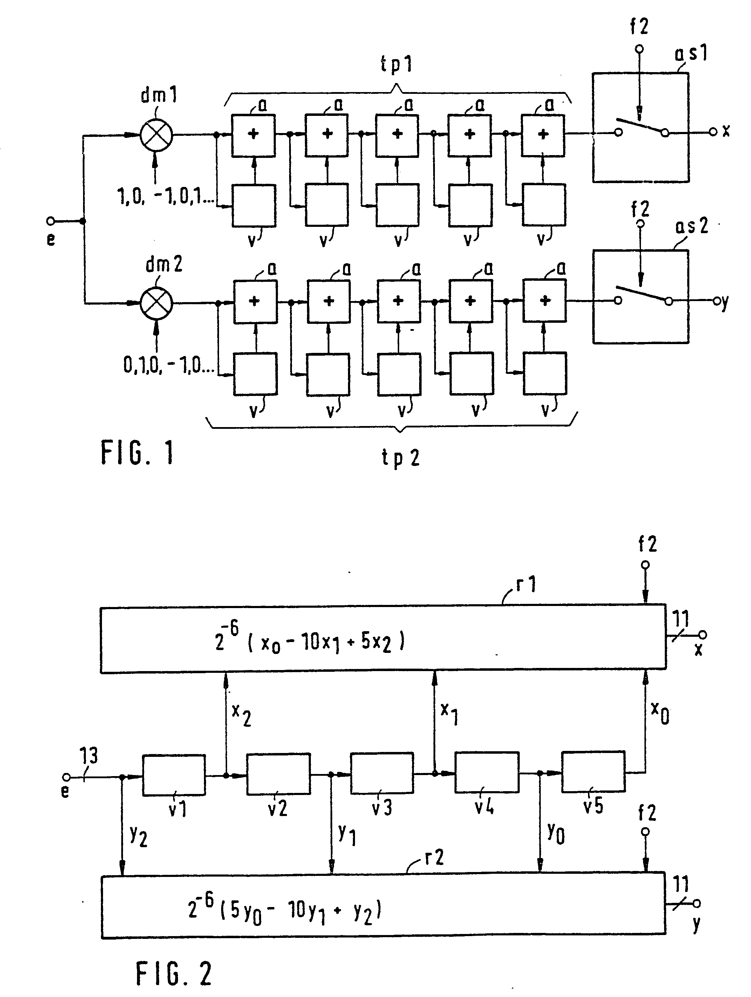

Das Prinzipschaltbild nach Fig. 1 zeigt die auch beim Stand der Technik vorhandenen Teilschaltungen, nämlich die in den vom Eingang e ausgehenden beiden Signalwegen in gleicher Weise angeordneten ersten bzw. zweiten Digitalmischer dm1, dm2, ferner das diesem nachgeschaltete erste bzw. zweite digitale Tiefpaßfilter tp1, tp2 und schließlich die diesem wiederum nachgeschaltete erste bzw. zweite Abtaststufe as1, as2, die vom zweiten Taktsignal f2 getaktet sind. Jeweils zu einem in jeder Periode gleichen Abtastzeitpunkt des ersten Taktsignals f1 sind dem ersten Digitalmischer dm1 Binärzahlen zugeführt, die den Dezimalzahlen 1, 0, -1, 0, 1... entsprechen, während dem zweiten Digitalmischer dm2 zu denselben Abtastzeitpunkten Binärzahlen zugeführt sind, die den Dezimalzahlen 0, 1, 0, -1, 0... entsprechen. Wie im eingangs genannten Stand der Technik angegeben ist, wird durch die Zuführung dieser Zahlenwerte eine Mischung des am Eingang e liegenden und aus einem entsprechenden, nicht gezeigten Analog-Digital-Wandler stammenden Digitalsignals mit zwei Signalen erreicht, die mit dem zweiten Taktsignal gleichfrequent sind, jedoch gegeneinander eine Phasenverschiebung von exakt 90° aufweisen.

In Fig. 1 sind die beiden Tiefpaßfilter tp1, tp2 als aus der Hintereinanderschaltung von fünf gleichen, einfachen, nichtrekursiven Digitalfilterstufen mit der Übertragungsfunktion $H'(z) = 1 + z^{-1}$ bestehend gezeigt, so daß die Übertragungsfunktion des jeweiligen Tiefpaßfilters tp1, tp2 lautet: $H(z) = (1+z^{-1})^5$. Mit z ist dabei die der Frequenz des ersten Taktsignals f1 entsprechende komplexe Frequenzvariable bezeichnet. Dabei sind die einzelnen Digitalfilterstufen untereinander identisch und bestehen jeweils aus der Verzögerungsstufe v, deren Verzögerungszeit gleich der Periodendauer des ersten Taktsignals f1 ist, und der Addierstufe a, die an ihrem einen Eingang das unverzögerte und an ihrem anderen Eingang das über die Verzögerungsstufe v verzögerte Eingangssignal zugeführt erhält. Am Ende des jeweiligen Signalwegs und somit am Ausgang des jeweiligen Digitalfilters tp1, tp2 liegt die erste bzw. zweite Abtaststufe as1, as2, die jeweils vom zweiten Taktsignal f2 getaktet sind, dessen Frequenz gleich einem Viertel der Frequenz des ersten Taktsignals f1 ist. Der Ausgang der ersten Abtaststufe as1 ist der Ausgang x des ersten Signalwegs und der der zweiten Abtaststufe as2 der Ausgang y des zweiten Signalwegs.

Obwohl in den Figuren der Zeichnung zwischen den einzelnen Teilschaltungen der zeichnerischen Einfachheit halber und der Anschaulichkeit wegen nur verbindende Linien gezeichnet sind, als ob nur jeweils eine einzelne Verbindungsleitung bestünde, handelt es sich jedoch jeweils um aus vielen parallelen Leitungen bestehende Busse, da die zu verarbeitenden Digitalsignale in paralleler Form vorliegen und die Signalverarbeitung in den einzelnen Stufen jeweils während einer Periodendauer des ersten Taktsignals f1 erfolgt und abgeschlossen ist. Dies wird auch daraus ersichtlich, daß die Frequenz des ersten Taktsignals f1 gleich der vierfachen Referenzträgerfrequenz des SECAM-Farbfernsehsignals und entsprechend die zweite Taktfrequenz f2 gleich dieser Referenzträgerfrequenz ist.

In Fig. 2 ist eine vorteilhafte Vereinfachung der Anordnung nach Fig. 1 gezeigt, bei der von den in Fig. 1 vorhandenen 10 Verzögerungsstufen v nur noch deren fünf, nämlich die Verzögerungsstufen v1, v2, v3, v4, v5, vorgesehen sind, die vom Eingang e aus signalflußmäßig in Reihe liegen und deren jeweiliges Eingangssignal y2, x2, y1, x1, y0, sowie das Ausgangssignal x0 der fünften Verzögerungsstufe v5 jeweils abwechselnd den beiden Signalwegen zugeführt sind. Im ersten Signalweg führen die Eingangssignale der zweiten und vierten sowie das Ausgangssignal der fünften Verzögerungsstufe v2, v4, v5 zu der ersten Rechenschaltung r1, die ausschließlich für die Berechnung des Terms $2^{-6} (x0-10x1+5x2)$ ausgelegt ist, während die Eingangssignale y2, y1, y5 der ersten, dritten, bzw. fünften Verzögerungsstufe v1, v3, v5 der zweiten Rechenschaltung r2 zugeführt sind, die ausschließlich für die Berechnung des Terms $2^{-6}$ (5y0-10y1+y2) ausgelegt ist. In Fig. 2 ist das oben bezüglich der verwendeten Busse Gesagte dadurch angedeutet, daß die mit dem Eingang e verbundene Leitung und die zu den Ausgängen x, y führenden Leitungen jeweils mit einem Schrägstrich und den Zahlen 13 bzw. 11 markiert sind, was andeuten soll, daß auf diesen Bussen 13- bzw. 11-stellige Digitalwörter in paralleler Form auftreten. Aus diesem Grund sind auch sämtliche Teilschaltungen bei der erfindungsgemäßen Anordnung solche zur parallelen Signalverarbeitung.

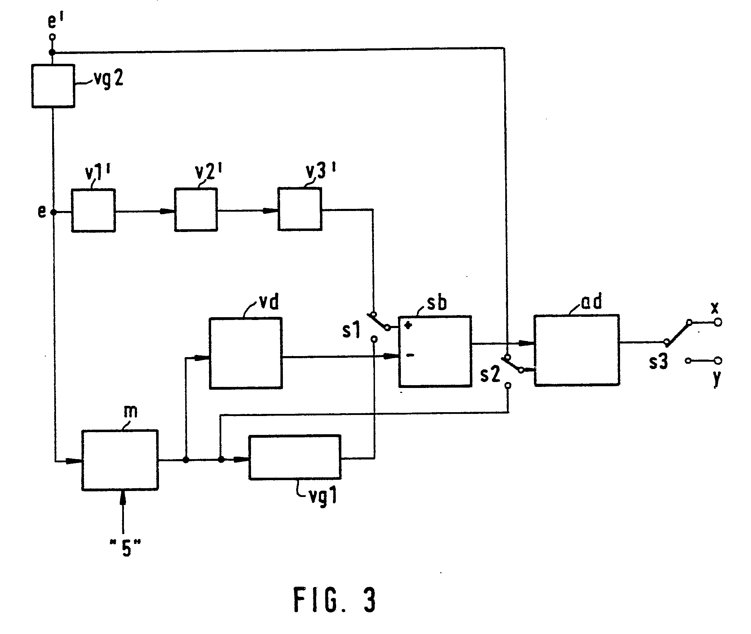

Die Fig. 3 zeigt schließlich ein Schaltbild einer weiteren Vereinfachung für den Fall, daß die Erfindung in der Technik der Zweiphasen-Isolierschicht-Feldeffekt-transistor-Schaltungen realisiert wird. Diese Technik ist lange bekannt und beispielsweise in « The Electronic Engineer », März 1970, Seiten 56 bis 61 beschrieben.

Bei dieser Realisierung sind die fünf Verzögerungsstufen vl...v5 nach Fig. 2, deren beide Rechenschaltungen r1, r2 und die beiden Abtaststufen as1, as2 nach Fig. 1 funktionell miteinander vereinigt, und zwar in der folgenden Art und Weise. Vom Eingang e aus sind die drei Verzögerungsstufen v1', v2', v3' signalflußmäßig in Serie geschaltet. Das erste Taktsignal f1 ist in die beiden damit gleichfrequenten Taktphasen ph1, ph2 des Zweiphasen-Taktes aufgeteilt. Zur Vorderflanke jeder ersten Taktphase ph1 wird das jeweilige Eingangssignal am Eingang e vom ersten Eingang des Multiplizierers m übernommen, dessen zweitem Eingang ein dem dezimalen Faktor « 5 » entsprechendes Binärwort zugeführt ist. Zur Vorderflanke jeder zweiten Taktphase ph2 gelangt das Ausgangssignal des Multiplizierers m an den Eingang der Verdopplungsstufe vd, d. h. einer Stufe, die das Ausgangssignal des Multiplizierers m mit einem dem dezimalen Faktor 2 entsprechenden Binärwort multipliziert. Dies kann in einfacher Weise bekanntlich dadurch geschehen, daß im natürlichen Binärcode eine Linksverschiebung des Ausgangssignals des Multiplizierers m um eine Stelle vorgenommen wird.

Das Ausgangssignal der Verdopplungsstufe vd gelangt zur nächsten Vorderflanke der ersten Taktphase ph1 an den Subtrahend-Eingang des Subtrahierers sb. Der Ausgang der dritten Verzögerungsstufe v3' liegt am ersten Eingang des ersten elektronischen Umschalters s1, dessen Ausgang mit dem Minuend-Eingang des Subtrahierers sb verbunden ist. Der Ausgang des Multiplizierers m ist ferner über das erste Verzögerungsglied vg1, das um die 2,5 fache Periodendauer des ersten Taktsignals f1 verzögert, am zweiten Eingang des ersten elektronischen Umschalters s1 angeschlossen. Der Ausgang des Subtrahierers sb liegt am ersten Eingang des Addierers ad. Dem Eingang e ist das zweite Verzögerungsglied vg2 vorgeschaltet, das um die halbe Periodendauer des ersten Taktsignals f1 verzögert. Der so gebildete Eingang e' ist mit dem ersten Eingang des zweiten elektronischen Umschalters s2 verbunden, dessen Ausgang am zweiten Eingang des Addierers ad und dessen zweiter Eingang am Ausgang des Multiplizierers m liegt.

Der jeweils erste Eingang der beiden Umschalter s1, s2 ist innerhalb von vier Periodendauern des ersten Taktsignals f1 während der zweiten und vierten Periode, deren jeweils zweiter Eingang dagegen während der ersten und dritten Periode zum jeweiligen Ausgang durchgeschaltet. Der Ausgang des Addierers ad ist mit dem Eingang des dritten elektronischen Umschalters s3 verbunden, der zum Ausgang x des ersten Signalwegs während der dritten Periode, dagegen zum Ausgang y des zweiten Signalwegs während der vierten Periode durchgeschaltet ist.

Wie bereits erwähnt wurde, erfolgt in den Teilschaltungen, die eine Berechnung vorzunehmen haben, also dem Multiplizierer m, dem Subtrahierer sb und dem Addierer ad die Berechnung innerhalb von maximal einer halben Periodendauer des ersten Taktsignals f1, d. h. innerhalb von maximal 28 ns. Derartige einfache Rechenschaltungen sind derzeit ohne weiteres realisierbar. Der Multiplizierer m kann besonders vorteilhaft als die Serienschaltung von zwei Addierern realisiert werden, deren erster eine Stellen-Linksverschiebung um zwei Stellen entsprechend einer Multiplikation mit dem dezimalen Faktor 4, und deren zweiter eine weitere Addition des Eingangssignals des Multiplizierers zu dem Ergebnis der Stellenverschiebung vornimmt. Am Subtrahend-Eingang des Subtrahierers sb liegt nach der einfachen Periodendauer des ersten Taktsignals f1 ein Signal, das dem zehnfachen Signalwert am Eingang e zum Ende der vorausgegangenen Periodendauer gleich ist. Vergleichbare Zeitbetrachtungen gelten auch für den anderen Eingang des Subtrahierers sb und die beiden Eingänge des Addierers ad.

## Patentansprüche

1. Integrierte digitale Frequenzdemodulationsteilschaltung,
— deren Eingang (e) ein mittels eines ersten Taktsignals (f1) abgetastetes und digitalisiertes frequenzmoduliertes Analogsignal, z. B. das Ausgangssignal eines Analog-Digital-Wandlers, zugeführt ist,
— die vom Eingang (e) aus einen ersten Signalweg mit einem ersten Digitalmischer (dm1), mit einem nachgeschalteten ersten digitalen Tiefpaßfilter (tp1) und mit einer diesem nachgeschalteten, von einem zweiten Taktsignal (f2) getakteten ersten Abtaststufe (as1) enthält, deren Ausgang (x) ein erstes Teildemodulationssignal liefert,
— die vom Eingang (e) aus einen zweiten Signalweg mit einem zweiten Digitalmischer (dm2), mit einem nachgeschalteten zweiten digitalen Tiefpaßfiler (tp2) und mit einer diesem nachgeschalteten, vom zweiten Taktsignal (f2) getakteten zweiten Abtaststufe (as2) enthält, deren Ausgang (y) ein zweites Teildemodulationssignal liefert,

— bei der jeweils zu einem in jeder Periode gleichen Abtastzeitpunkt des ersten Taktsignals (f1) dem ersten Digitalmischer (dm1) den Dezimalzahlen 1, 0, -1, 0, 1... entsprechende Binärzahlen und dem zweiten Digitalmischer (dm2) den Dezimalzahlen 0, 1, 0, -1, 0... entsprechende Binärzahlen zugeführt sind und

— bei der das erste Taktsignal (f1) die vierfache Frequenz des zweiten Taktsignals (f2) hat, gekennzeichnet durch folgendes Merkmal zur Frequenzdemodulation von SECAM-Farbfernsehsignalen :

— die beiden Tiefpaßfilter (tp1, tp2) haben jeweils die Übertragungsfunktion H(z) = $(1+z^{-1})^5$, wobei z die der Frequenz des ersten Taktsignals (f1) entsprechende komplexe Frequenzvariable ist und durch $z^{-1}$ die der Periodendauer des ersten Taktsignals (f1) entsprechende jeweilige Verzögerung von gleichen Verzögerungsstufen (v) symbolisiert ist, die die Tiefpaßfilter enthalten.

2. Integrierte digitale Frequenzdemodulationsteilschaltung nach Anspruch 1, dadurch gekennzeichnet, daß die jeweils beiden Digitalmischer (dm1, dm2), Tiefpaßfilter (tp1, tp2) und Abtaststufen (as1, as2) funktionell miteinander vereinigt sind.

3. Integrierte digitale Frequenzdemodulationsteilschaltung nach Anspruch 2, gekennzeichnet durch folgende Merkmale :

— anstatt der insgesamt zehn Verzögerungsstufen (v) der beiden Tiefpaßfilter (tp1, tp2) sind nur deren fünf (v1....v5) vorgesehen, die signalflußmäßig vom Eingang (e) aus in Serie liegen und an deren Eingang der Reihe nach die Signal y2, x2, y1, x1, y0 abgezweigt sind, wobei das der ersten Verzögerungsstufe (v1) zugeführte Signal y2 das dem Eingang (e) zugeführte Signal ist und wobei das Ausgangssignal der letzten Verzögerungsstufe (v5) das Signal x0 ist,

— es ist eine erste Rechenschaltung (r1) vorgesehen, der als Eingangssignale die Signale x2, x1, x0 und das zweite Taktsignal (f2) zugeführt sind, die ausschließlich für die Berechnung des Therms $2^{-6}$ (x0 - 10x1 + 5x2) ausgelegt ist und die diesen Therm als erstes Teilmodulationssignal am Ausgang (x) abgibt, und

— es ist eine zweite Rechenschaltung (r2) vorgesehen, der als Eingangssignale die Signale y2, y1, y0 und das zweite Taktsignal (f2) zugeführt sind, die ausschließlich für die Berechnung des Therms $2^{-6}$ (5y0 - 10y1 + y2) ausgelegt ist und die diesen Therm als zweites Teildemodulationssignal am Ausgang (y) abgibt.

4. Integrierte digitale Frequenzdemodulationsteilschaltung nach Anspruch 3, realisiert in zweiphasen-getakteter Isolierschicht-Feldeffekt-Transistortechnik, dadurch gekennzeichnet, daß die fünf Verzögerungsstufen (v1...v5), die beiden Rechenschaltungen (r1, r2) und die beiden Abtaststufen (as1, as2) funktionell wie folgt miteinander vereinigt sind :

— das erste Taktsignal (f1) ist in die beiden damit gleichfrequenten Taktphasen (ph1, ph2) des Zwei-Phasen-Taktes aufgeteilt,

— vom Eingang (e) aus sind drei Verzögerungsstufen (v1', v2', v3') signalflußmäßig in Serie geschaltet,

— zur Vorderflanke jeder ersten Taktphase (ph1) wird das jeweilige Eingangssignal am Eingang (e) vom ersten Eingang eines Multiplizierers (m) übernommen, dessen zweitem Eingang ein dem dezimalen Faktor « 5 » entsprechendes Binärwort zugeführt ist,

— zur Vorderflanke jeder zweiten Taktphase (ph2) gelangt das Ausgangssignal des Multiplizierers (m) an den Eingang einer Verdopplungsstufe (vd), deren Ausgangssignal zur nächsten Vorderflanke der ersten Taktphase (ph1) an den Subtrahend-Eingang eines Subtrahierers (sb) gelangt,

— der Ausgang der dritten Verzögerungsstufe (v3') liegt am ersten Eingang eines ersten elektronischen Umschalters (s1), dessen Ausgang mit dem Minuend-Eingang des Subtrahierers (sb) verbunden ist,

— der Ausgang des Multiplizierers (m) ist über ein erstes Verzögerungsglied (vg1), das um die 2,5 fache Periodendauer des ersten Taktsignals (f1) verzögert, am zweiten Eingang des ersten elektronischen Umschalters (s1) angeschlossen,

— der Ausgang des Subtrahierers (sb) liegt am ersten Eingang eines Addierers (ad),

— dem Eingang (e) ist ein zweites Verzögerungsglied (vg2) vorgeschaltet, das um die halbe Periodendauer des ersten Taktsignals (f1) verzögert,

— der so gebildete Eingang (e') ist mit dem ersten Eingang eines zweiten elektronischen Umschalters (s2) verbunden, dessen Ausgang am zweiten Eingang des Addierers (ad) und dessen zweiter Eingang am Ausgang des Multiplizierers (m) liegt,

— der jeweils erste Eingang der beiden Umschalter (s1, s2) ist innerhalb von vier Periodendauern des ersten Taktsignals (f1) während der zweiten und vierten Periode, deren jeweils zweiter Eingang dagegen während der ersten und dritten Periode zum jeweiligen Ausgang durchgeschaltet, und

— der Ausgang des Addierers (ad) ist mit dem Eingang eines dritten elektronischen Umschalters (s3) verbunden, der zum Ausgang (x) des ersten Signalwegs während der dritten Periode, dagegen zum Ausgang (y) des zweiten Signalwegs während der vierten Periode durchgeschaltet ist.

## Claims

1. Digital integrated frequency demodulator subcircuit

— whose input (e) is presented with a frequencymodulated analog signal, e.g., the output signal of an analog-to-digital converter, which is sampled by means of a first clock signal (f1) ;

— which contains a first signal path connected to the input (e) and comprising a first digital mixer (dm1), a first digital low-pass filter (fp1) following the first digital mixer (dm1), and a first sampling stage (as1) following the first digital low-pass filter (fp1) and clocked with a second clock signal (f2) ;

— which contains a second signal path connected to the input (e) and comprising a second digital mixer (dm2), a second digital low-pass filter (tp2) following the second digital mixer (dm2), and a second sampling stage (as2) following the second digital low-pass filter (tp2) and clocked with the second clock signal (f2) ;

— wherein at the same sampling instant in each period of the first clock signal (f1), binary numbers equivalent to the decimal numbers 1, 0, -1, 0, 1... are fed to the first digital mixer (dm1), and binary numbers equivalent to the decimal numbers 0, 1, 0, -1, 0... are fed to the second digital mixer (dm2), and

— wherein the first clock signal (f1) has four times the frequency of the second clock signal (12) characterized by the following feature for frequency demodulation in SECAM color-television sets :

— Each of the two low-pass filters (tp1, tp2) has the transfer function $H(z)=(1+z^{-1})^5$, where z is the complex frequency variable corresponding to the frequency of the first clock signal (f1), and $z^{-1}$ symbolizes the delay produced by each of a number of like delay stages (v) contained in the low-pass filters, said delay being equal to the period of the first clock signal (f1).

2. A digital integrated frequency demodulator subcircuit as claimed in claim 1, characterized in that the two digital mixers (dm1, dm2), the two low-pass filters (tp1, tp2), and the two sampling stages (as1, as2) are functionally united.

3. A digital intergrated frequency demodulator subcircuit as claimed in claim 2, characterized by the following features :

— Instead of the total of ten delay stages (v) of the two low-pass filters (tp1, tp2), only five (v1...v5) are provided which are connected to the input (e) in a cascade arrangement, their inputs being presented with the signals y2, x2, y1, x1, and y0, respectively, and the output of the fifth delay stage (v5) delivering the signal x0 ;

— there is provided a first computing circuit (r1) which is designed exclusively to compute the term $2^{-6}(x0 - 10x1 - 5x2)$, and

— there is provided a second computing circuit (r2) which is designed exclusively to compute the term $2^{-6}(5y0 - 10y1 + y2)$.

4. A digital integrated frequency demodulator subcircuit as claimed in claim 3, implemented using two-phase-clocked insulated-gate field-effect transistor technology, characterized in that the five delay stages (v1...v5), the two computing circuits (r1, r2), and the two sampling stages (as1, as2) are functionally united as follows :

— The first clock signal (f1) is divided into the two clock phases (ph1, ph2) of the two-phase clock system, which have the same frequency as the first clock signal (f1) ;

— the input (e) is followed by three cascaded delay stages (v1', v2', v3') ;

— on the leading edge of each first clock phase (ph1), the respective signal at the input (e) is transferred to the first input of a multiplier (m) whose second input is supplied with a binary word corresponding to the decimal factor « 5 » ;

— on the leading edge of each second clock phase (ph2), the output signal of the multiplier (m) is transferred to the input of a doubler stage (vd) whose output signal is applied to the subtrahend input of a subtracter (sb) on the next leading edge of the first clock phase (ph1) ;

— the output of the third delay stage (v3') is coupled to the first input of a first electronic switch (s1) having its output connected to the minuend input of the subtracter (sb) ;

— the output of the multiplier (m) is connected to the second input of the first electronic switch (s1) through a first delay element (vg1) giving a delay equal to 2.5 times the period of the first clock signal (f1) ;

— the output of the subtracter (sb) is coupled to the first input of an adder (ad) ;

— the input (e) is preceded by a second delay element (vg2) giving a delay equal to half the period of first clock signal (f1) ;

— the input thus formed (e') is connected to the first input of a second electronic switch (s2) having its second input connected to the output of the multiplier (m) and having its output coupled to the second input of the adder (ad) ;

— within four periods of the first clock signal (f1), the first input of each of the two switches (s1, s2) is connected to the output of the respective switch during the second and fourth periods, and the second input during the first and third periods, and

— the output of the adder (ad) is coupled to the input of a third electronic switch (s3), which input is connected to the output (x) of the first signal path during the third period, and to the output (y) of the second signal path during the fourth period.

**Revendications**

1. Circuit partiel intégré et numérique de démodulation de fréquence ;

— à l'entrée (e) duquel est amené au moyen d'un premier signal de synchronisation (f1) un signal analogique analysé et numérisé, modulé en fréquence, tel que, par exemple, le signal de sortie d'un convertisseur analogique-numérique,

— qui comporte, à partir de l'entrée (e), un premier parcours de signaux pourvu d'un premier mélangeur numérique (dm1), d'un premier filtre passe-bas numérique (tp1) connecté en aval et d'un premier étage d'analyse (as1) monté en aval de ce dernier et synchronisé par un deuxième signal de synchronisation (f2), dont la sortie (x) fournit un premier signal partiel de démodulation,

— qui comporte, à partir de l'entrée (e) un deuxième parcours de signaux pourvu d'un deuxième mélangeur numérique (dm2) d'un deuxième filtre passe-bas numérique (tp2) connecté en aval et d'un deuxième étage d'analyse (as2) monté en aval de ce dernier et synchronisé par le deuxième signal de synchronisation (f2), dont la sortie (y) fournit un deuxième signal partiel de démodulation,

— dans lequel à un moment de l'analyse du premier signal de synchronisation (f1), qui est le même au cours de chaque période, il est amené au premier mélangeur digital (dm1) des nombres binaires qui correspondent aux nombres décimaux 1, 0 -1, 0, 1... et au deuxième mélangeur numérique (dm2) des nombres binaires qui correspondent aux nombres décimaux 0, 1, 0, -1, 0...,

— dans lequel le premier signal de synchronisation (f1) a une fréquence quadruple de celle du deuxième signal de synchronisation (f2), caractérisé comme suit pour la démodulation de fréquence de signaux de télévision en couleur SECAM :

— les deux filtres passe-bas (tp1, tp2) assument chacun la fonction de transmission $H(z) = (1 + z^{-1})^5$, où z désigne la variable de fréquence complexe qui correspond à la fréquence du premier signal de synchronisation (f1) et où le retard respectif, qui correspond à la durée de la période du premier signal de synchronisation (f1), d'étages de retard (v) identiques que contiennent les filtres passe-bas, est symbolisé par $z^{-1}$.

2. Circuit partiel intégré et numérique de démodulation de fréquence selon la revendication 1, caractérisé en ce que les deux mélangeurs numériques (dm1, dm2), les filtres passe-bas (tp1, tp2) et les étages d'analyse (as1, as2) sont reliés respectivement entre eux, et constituent des unités fonctionnelles.

3. Circuit partiel intégré et numérique de démodulation de fréquence selon la revendication 2, caractérisé comme suit :

— il n'est prévu, à la place d'un total de dix étages de retard (v) pour les deux filtres passe-bas (tp1, tp2), que cinq étages (v1 à v5) qui sont montés en série à partir de l'entrée (e) dans le sens de circulation des signaux et à l'entrée desquels les signaux y2, x2, y1, x1, y0 sont dérivés dans l'ordre, de telle sorte que le signal y2 amené au premier étage de retard (v1) est le signal amené à l'entrée (e) et que le signal de sortie du dernier étage de retard (v5) est le signal x0,

— il est prévu un premier circuit de calcul (r1) auquel sont amenés, en tant que signaux d'entrée, les signaux x2, x1, x0 et le deuxième signal de synchronisation (f2), qui est exclusivement conçu pour le calcul du terme $2^{-6}(x0 - 10x1 + 5x2)$ et qui remet ce terme à la sortie (x), en tant que premier signal partiel de démodulation,

— il est prévu un deuxième circuit de calcul (r2) auquel sont amenés, en tant que signaux d'entrée, les signaux y2, y1, y0 et le deuxième signal de synchronisation (f2), qui est exclusivement conçu pour le calcul du terme $2^{-6}(5y0 - 10y1 + y2)$ et qui remet ce terme à la sortie (y), en tant que deuxième signal partiel de démodulation.

4. Circuit partiel intégré et numérique de démodulation de fréquence selon la revendication 3, réalisé selon une technique avec transistors à effet de champ à couche isolante synchronisé avec deux phases, caractérisé en ce que les cinq étages de temporisation (v1 à v5), les deux circuits de calcul (r1, r2) et les deux étages d'analyse (as1, as2) sont réunis fonctionnellement de la manière suivante :

— le premier signal de synchronisation (f1) est partagé entre les deux phases de synchronisation (ph1, ph2) de la synchronisation biphasée,

— les trois étages de retard (v1', v2', v3') sont montés en série à partir de l'entrée (e) selon le sens de circulation des signaux,

— le signal d'entrée à l'entrée (e) est reçu sur le flanc avant de chacune des premières phases de synchronisation (ph1) par la première entrée d'un multiplicateur (m), à la seconde entrée duquel est amené un mot binaire correspondant au facteur décimal « 5 »,

— sur le flanc avant de chacune des deux phases de synchronisation (mh2), le signal de sortie du multiplicateur (m) atteint l'entrée de l'étage de duplication (vd), dont le signal de sortie atteint, sur le flanc avant suivant de la première phase de rythme (ph1), l'entrée de soustraction d'un soustracteur (sb),

— la sortie du troisième étage de retard (v3') se trouve sur la première entrée d'un premier inverseur électronique (s1), dont la sortie est reliée à l'entrée diminuende du soustracteur (sb),

— la sortie du multiplicateur (m) est reliée au moyen d'un premier élément de retard (vgl), dont le retard correspond à 2,5 fois la durée de la période du premier signal de synchronisation (f1), à la deuxième entrée du premier inverseur électronique (s1),

— la sortie du soustracteur (sb) est appliquée à la première entrée d'un additionneur (ad),

— un deuxième élément de retard (vg2), qui retarde de la moitié de la durée d'une période le premier signal de synchronisation (f1) est monté en amont de l'entrée (e),

— l'entrée (e') ainsi constituée est reliée à la première entrée d'un deuxième inverseur électronique (s2), dont la sortie est appliquée à la deuxième entrée de l'additionneur (ad) et la deuxième entrée à la sortie du multiplicateur (m),

— la première entrée de chacun des deux inverseurs (s1, s2) est, pendant la durée de quatre périodes du premier signal de synchronisation (f1), interconnectée pendant la deuxième et la quatrième périodes, avec la sortie correspondante, tandis que leur deuxième entrée l'est pendant la première et la troisième périodes,

— la sortie de l'additionneur (ad) est reliée à l'entrée d'un troisième inverseur électronique (s3), qui est interconnectée avec la sortie (x) de la première voie de signaux pendant la troisième période, mais, par contre, avec la sortie (y) de la deuxième voie de signaux pendant la quatrième période.

# 0 192 788

FIG. 1

FIG. 2

**0 192 788**

FIG. 3